# EUROPEAN PATENT APPLICATION

(11) **EP 1 316 850 A1**
(43) Date of publication of application: **04.06.2003**
(21) Application number: 02258182.1
(22) Date of filing: 27.11.2002
(51) Int. Cl.: G03F 7/20

(54) **Lithographic apparatus and device manufacturing method**

(30) Priority: 30.11.2001 EP 01204598
(71) Applicant: ASML Netherlands B.V., 5503 LA Veldhoven (NL)
(72) Inventor: Van der Mast, Karel Diederick, 5708 BB Helmond (NL)
(74) Representative: Leeming, John Gerard

(57) **Abstract**

Providing grayscales by simultaneously projecting two or more patterned projection beams onto the substrate, each of which has a different pattern and a different intensity

## Description

The present invention relates to a lithographic projection apparatus comprising:
- a radiation system for providing a first projection beam of radiation;
- first programmable patterning means for patterning the first projection beam according to a first desired pattern;
- a substrate table for holding a substrate;
- a projection system for projecting the first patterned projection beam onto a target portion of the substrate.

The term "programmable patterning means" as here employed should be broadly interpreted as referring to means that can be used to endow an incoming radiation beam with a patterned cross-section, corresponding to a pattern that is to be created in a target portion of the substrate; the terms "light valve" and "Spatial Light Modulator" (SLM) can also be used in this context. Generally, the said pattern will correspond to a particular functional layer in a device being created in the target portion, such as an integrated circuit or other device (see below). Examples of such patterning means include:
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the programmable patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the programmable patterning means as hereabove set forth.

Lithographic projection apparatus can be used, for example, in the manufacture of integrated circuits (ICs). In such a case, the programmable patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

At present imaging apparatus as specified in the opening paragraph is currently employed to make mask writing machines, e.g. by the firm Micronic in Sweden. Such a mask can be used in a lithographic projection apparatus, which repetitively images the mask pattern onto a photo-sensitive substrate - such as a photoresist-coated silicon wafer - as part of the broader manufacturing process involved in producing integrated devices, such as integrated circuits (Ics). The substrate in such a mask writing machine is, for example, a metallized plate (e.g. a Cr-coated quartz or CaF₂ plate) that has been coated with a layer of photoresist. The idea behind such a mask writing machine is that an electronic file of the (highly complex) mask pattern is used to matrix-address the patterning means, which then divert a patterned radiation beam onto a small portion of the mask plate. By changing the pattern in the patterned beam in accordance with the electronic file, and concurrently moving the beam over the whole surface of the mask plate (in either a scanning or a stepping motion), the final mask pattern is built up as a sum of combined (juxtaposed) sub-patterns from the patterned beam. For this reason, such a machine is sometimes referred to as a "direct-write" machine.

Although machines as described in the previous paragraph have heretofore been used only in the manufacture of masks, it is - at least in principle - possible to use them in the manufacture of semiconductor and other integrated devices. In such a case, the mask plate would be replaced by, for example, a Si wafer, and the pattern built up on the wafer by the patterning means would correspond to an array of die patterns. However, a major drawback of such an application would be its very low throughput: whereas current direct-write machines might be expected to achieve a throughput of the order of one substrate per day, a state-of-the-art lithographic projection apparatus has a throughput of the order of 100 substrates per hour. Nevertheless, it might still be interesting to pursue such an application: for example, in the case of a foundry making a small batch of a particular integrated device (such as a dedicated ASIC), it might be more attractive to endure a slow direct-write process as delivered by a machine as described above rather than to entail the very high costs (often of the order of 50-1000 US dollars) of making a special mask for the batch in question. At the moment, such a choice might only be attractive in the case of a very small batch of a very expensive device; however, it would become much more attractive if the throughput of direct-write machines could be increased. More information with regard to conventional lithographic apparatus as here described can be gleaned, for example, from US 6,046,792, incorporated herein by reference.

In direct-write machines such as the hereabove referred to, it is desirable not only to produce patterns having black and white shades (binary patterns), but also to allow the creation of intermediate gray shades (grayscaling). In prior art machines, such grayscaling can be achieved in different manners. For example, in a Programmable Mirror Array (PMA) employing tiltable mirrors, each mirror (pixel) can be embodied to allow intermediate tilts (either continuously or discretely) between the zero-tilt and full-tilt extremes. Similarly, in a PMA employing mirrors that translate up and down in a piston-like fashion - causing phase shifts in coherent light reflected from those mirrors - each mirror can be embodied to allow intermediate translations short of the full amplitude, thus allowing phase-shifts at values between 0 and ?. However, a disadvantage of these prior-art methods is that they require relatively complicated actuation means to move each mirror; as a result, they tend to be relatively slow in their operation, which entails a throughput penalty. Moreover, the manufacture of such actuation means is relatively difficult, and can often only be done with a relatively low yield, thus increasing manufacturing costs.

It is an object of the present invention to alleviate these problems. More specifically, it is an object of the present invention to provide an apparatus as describe in the opening paragraph, which apparatus is capable of performing grayscaling with a relatively high throughput and which can be manufactured with a relatively high yield.

This and other objects are achieved according to the invention in a lithographic apparatus as specified in the opening paragraph, characterized in that said apparatus further comprises second programmable patterning means for patterning a second projection beam provided by the radiation system according to a second desired pattern;
said projection system projects the second patterned projection beam onto said target portion of the substrate; and
the intensities of the first and second patterned projection beams are different.

This is advantageous since the apparatus can project a grayscale pattern onto the substrate instantaneously. By using different intensities for each patterned projection beam, the number of grayscales attainable for a given number of patterned projection means is larger. Use of a greater number of programmable patterning means producing patterned projection beams, preferably each with yet further differing intensities, provides a greater number of grayscales.

A beam splitter may be used to split the projection beam from the radiation source into the required number of projection beams for illuminating the programmable patterning means. The beam splitters may be arranged such that they illuminate the patterning means with projection beams of different intensities. Such a scheme inherently produces patterned projection beams with different intensities without necessarily reducing the overall intensity of the beam projected onto the substrate.

Alternatively, variable attenuators may be provided to reduce the intensity of the patterned projection beams projected onto the substrate. These may, for example, be placed to reduce the intensity of the projection beams that are incident on the patterning means and/or may be located in the beam path of the patterned projection beams to directly reduce the intensity of the patterned projection beams. The complexity of the radiation system may therefore be reduced.

A further means of varying the intensity of the patterned projection beams may be provided by the use of two or more separate radiation sources, producing projection beams with different intensities.

Depending on circumstance, it may be desirable to combine each of the patterned projection beams into a single patterned projection beam that is projected onto the target portion of the substrate. Advantageously, this requires only a single projection system, thus keeping the apparatus costs to a minimum. Alternatively, each patterned projection system may be independently projected onto the target portion of the substrate, obviating the requirement for a means of combining the patterned projection beams.

In addition to producing grayscales by simultaneously projecting a plurality of patterns onto the target portion of the substrate, one or more of the programmable patterning means may be used to pattern the projection beam for additional exposures that are projected onto the same target portion of the substrate. By such means further grayscales can be provided without the number of programmable patterning means becoming excessively large.

According to a further aspect of the invention there is provided:
a device manufacturing method comprising the steps of:
   - providing a substrate that is at least partially covered by a layer of radiation sensitive material;
   - providing a first projection beam of radiation using a radiation system;
   - using first programmable patterning means to endow the first projection beam with a first pattern in its cross-section;
   - projecting the first patterned projection beam of radiation onto a target portion of the layer of radiation-sensitive material,
   characterized by
   - providing a second projection beam of radiation;
   - providing second programmable patterning means to endow the second projection beam with a second pattern in its cross-section; and
   - projecting the second patterned projection beam of radiation onto said target portion of the layer of radiation sensitive material;
   wherein said first and second patterned projection beams have different intensities.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e*.*g*. with a wavelength of 365, 248, 193, 157 or 126 nm) and EUV (extreme ultra-violet radiation, *e*.*g*. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts part of an imaging apparatus according to a particular embodiment of the invention;
Figure 3 illustrates the grayscaling principle employed by the invention; and
Figure 4 depicts part of an imaging apparatus according to another embodiment of the invention.

In the Figures, corresponding reference symbols indicate corresponding parts.

### Embodiment 1

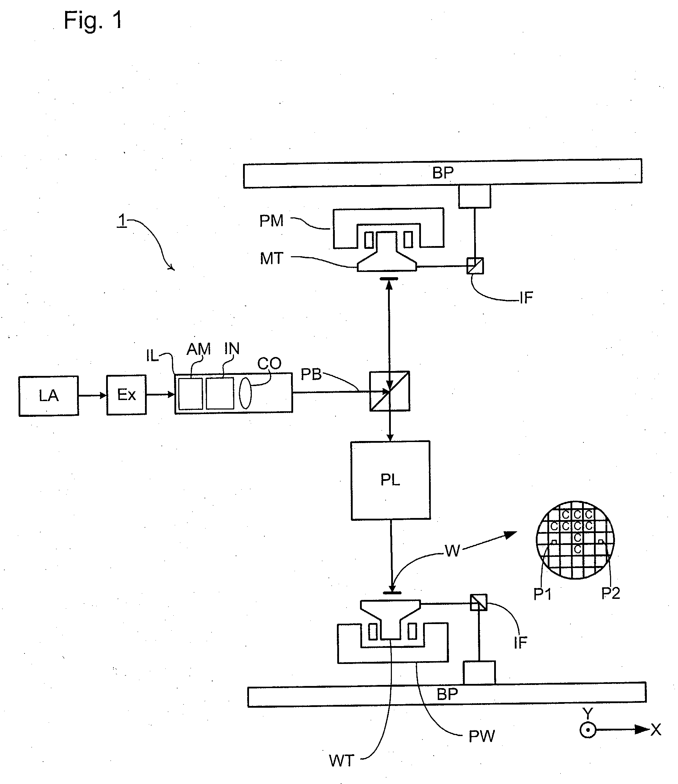

Figure 1 schematically depicts a lithographic projection apparatus according to a particular embodiment of the invention. The apparatus comprises:
- a radiation system Ex, IL, for supplying a projection beam PB of radiation (*e*.*g*. UV radiation), which in this particular case also comprises a radiation source LA;
- a first object table (mask table) MT provided with a mask holder for holding a programmable patterning means MA (*e*.*g*. an SLM), and connected to first positioning means for accurately positioning the programmable patterning means with respect to item PL;
- a second object table (substrate table) WT provided with a substrate holder for holding a substrate W (*e.g.* a resist-coated silicon wafer), and connected to second positioning means for accurately positioning the substrate with respect to item PL;
- a projection system ("lens") PL (*e*.*g*. a refractive mirror group) for imaging an irradiated portion of the programmable patterning means MA onto a target portion C (*e*.*g*. comprising one or more dies) of the substrate W.

As here depicted, the apparatus is of a reflective type (*e*.*g*. has a reflective programmable patterning means). However, in general, it may also be of a transmissive type, for example (*e*.*g*. with a transmissive programmable patterning means). Alternatively, the apparatus may employ another kind of patterning means, such as a programmable LCD array of a type as referred to above.

The source LA (*e*.*g*. an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as ? -outer and ? -inner, respectively) of the intensity distribution in the beam. In addition, it will generally comprise various other components, such as an integrator IN and a condenser CO. In this way, the beam PB impinging on the programmable patterning means MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the programmable patterning means MA, which is held on a mask table MT. Having been reflected by the programmable patterning means MA, the beam PB passes through the lens PL, which focuses the beam PB onto a target portion C of the substrate W. With the aid of the second positioning means (and interferometric measuring means IF), the substrate table WT can be moved accurately, *e*.*g*. so as to position different target portions C in the path of the beam PB. Similarly, the first positioning means can be used to accurately position the programmable patterning means MA with respect to the path of the beam PB, *e*.*g*. during a scan. The first positioning means may be omitted, in which case the position of the programmable patterning means relative to the beam PB will be fixed. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in three different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB.
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.
3. In pulse mode, the mask table is kept essentially stationary and an entire image of the programmable patterning means is projected onto a target portion C of the substrate. The substrate table WT is moved with an essentially constant speed such that the projection beam PB is caused to scan a line across the substrate W. The pulses of the radiation system are timed such that successive target portions C that are exposed on the substrate are adjacent to one another. Consequently, once the projection bean has scanned an entire line of the substrate W the complete pattern for that line is exposed on the substrate. The process is repeated until the complete substrate has been exposed line by line.

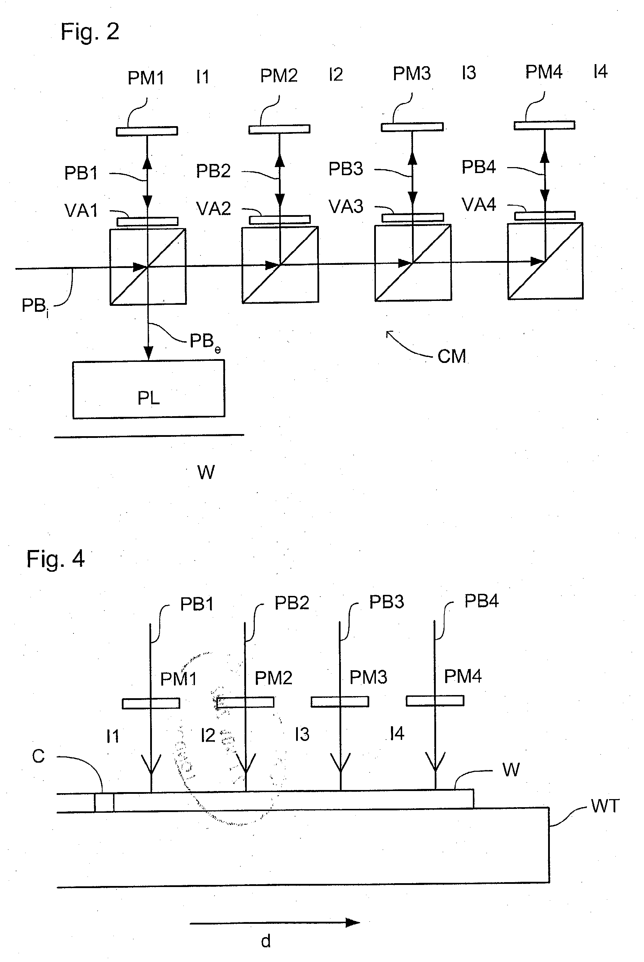

Figure 2 depicts part of an imaging apparatus according to a particular embodiment of the invention. In this embodiment, the programmable patterning means MA of Figure 1 comprise a plurality N=4 of component patterning means PM1, PM2, PM3, PM4. In addition, the beam PB is directed towards the patterning means MA by 4 mirror blocks, which serve to divide the incident projection beam PBᵢ into component projection beams PB1, PB2, PB3, PB4. These component projection beams PB1, PB2, PB3, PB4 are then reflected from, and patterned by, their respective component patterning means PM1, PM2, PM3, PM4. As here depicted, each component projection beam PB1, PB2, PB3, PB4 passes through its own variable attenuator VA1, VA2, VA3, VA4, resulting in individual intensities I1, I2, I3, I4 in the four component projection beams; the relative values of I1-14 can then be chosen according to will.

Alternatively, one may omit (at least some of) the variable attenuators VA1-VA4 and simply accept the intrinsic values of I1-14 resulting from the nature of the beam splitting means BS.

After being patterned, the component projection beams PB1, PB3, PB3, PB4 are reflected back to their respective mirror blocks, which serve to combine the component projection beams into a single, composite, emergent projection beam PBₑ. The mirror blocks therefore serve the function of combining means CM. Alternatively, the component projection beams PB1, PB2, PB3, PB4 may be independently projected onto the target portion of the substrate.

It will be appreciated that the required variation in I₁, I₂, I₃...Iₙ can be achieved in different ways. The radiation system may comprise a different radiation source (such as a laser or lamp) for each component patterning means: Iₙ can then be varied by varying the output power of each radiation source, or by employing a variable attenuator between each radiation source and its corresponding component patterning means, for example.

Depending *inter alia* on the relative values of I1-I4, various degrees of grayscaling can be achieved in the emergent projection beam PBₑ, which passes on to the projection system PL and, ultimately, the substrate W. The principle of this grayscaling will next be elucidated.

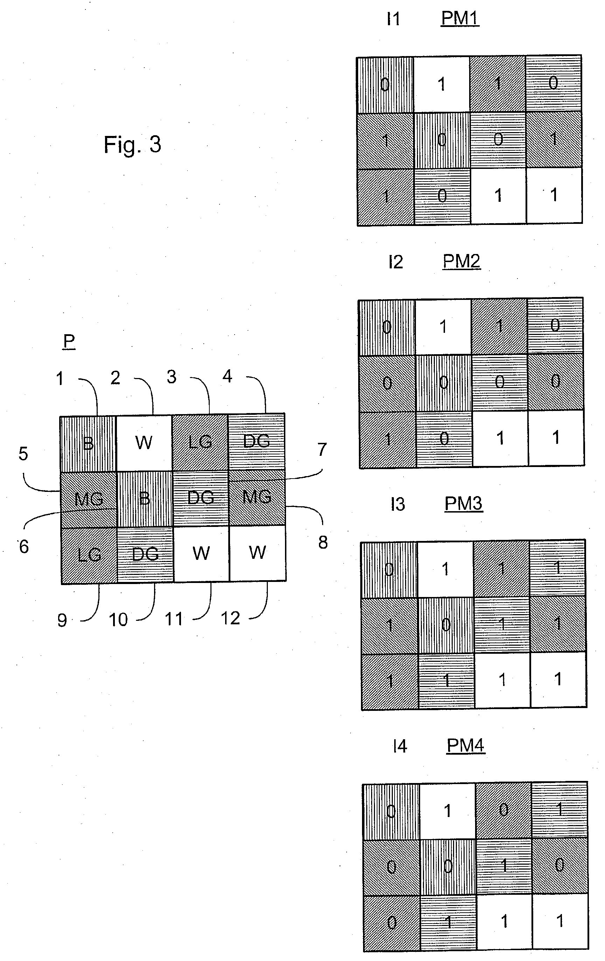

Figure 3 schematically depicts the grayscaling principles employed in the current invention, on the basis of a highly simplified pattern P. As shown in the left part of the Figure, the pattern P comprises 12 pixel positions, each of which is labeled with an ordinal 1-12. The various pixel positions have different "tints", as follows:
- pixel positions 1 and 6 are "black" (B);
- pixel positions 4, 7 and 10 are "dark gray" (DG);
- pixel positions 5 and 8 are "medium gray" (MG);
- pixel positions 3 and 9 are "light gray" (LG);
- positions 2, 11 and 12 are "white" (W).

The lower part of the Figure shows how the current invention can be employed to achieve the grayscaling effects (i.e. the intermediate tints DG, MG and LG) in the pattern. To this end, the Figure shows the four component patterning means PM1-PM4 of Figure 2, together with the proposed pixel configurations which, when combined, will achieve the pattern P. Since each of the component patterning means is of a binary type, its individual pixels can be either "on" (1) or "off" (0), respectively meaning that they either pass light to the substrate or block it. In this respect, the following is noted:
- Pixel positions 1 and 6 are "off" in all four component patterning means. These positions will therefore be "black" in the resulting pattern P, as desired.
- Pixel positions 2, 11 and 12 are "on" in all four component patterning means. These positions will therefore receive maximum intensity I ("white") in the resulting pattern P, as desired.
- Pixel positions 3 and 9 are "on" in component patterning means PM1-PM3, but "off" in component patterning means PM4. These positions in the pattern P therefore receive intensities I1+I2+I3, but not I4. They will therefore be relatively bright, but will not be "white". In this manner, a "light gray" tint is achieved, as desired.
- Pixel positions 5 and 8 are "on" in patterning means PM1 and PM3, but "off' in patterning means PM2 and PM4. These positions in the pattern P therefore receive intensity I1+I3, but not I2+I4. They will therefore be less bright than the case in the previous paragraph. In this manner, a "medium gray" tint is achieved, as desired.
- Pixel positions 4, 7 and 9 are "on" in patterning means PM3 and PM4, but "off" in patterning means PM1 and PM2. these positions in the pattern P therefore receive intensity I3+I4, but not I1+I2. They will therefore be less bright than the case in the previous paragraph (since I1>I2>I3>I4 in this particular embodiment). In this manner, a "dark gray" tint is achieved, as desired.
It will be immediately obvious to the skilled artisan that many different (alternative) permutations of the pixel configurations in component patterning means PM1-PM4 can be employed in a similar manner to achieve many different gray "tints".

By properly choosing different values for Iₙ (ₙbeing 4 in the above example), it is possible to achieve grayscaling over a wide range of values. One can, for example, choose the intensities Iₙ such that I₁:I₂:I₃:I₄...Iₙ = 1:2:4:8...2ⁿ⁻¹. This provides the greatest number of grayscales attainable for a given number of component patterning means. Alternatively, allowing grayscaling "tints" even if one of the component patterning means falls out of operation, one might choose the intensities Iₙ such that I₁:I₂:I₃:I₄:I₅... Iₙ = 1:1:2:3:5... Iₙ₋₂+ Iₙ₋₁. Apart from these examples there are, of course, many other possibilities.

Figure 4 shows a detail of a means of producing additional gray "tints" according to the invention. For simplicity, this Figure does not show the details of how the component projection beams PB1-PB4 are generated or directed towards their respective component patterning means PM1-PM4, nor does it show the optics employed to focus the component projection beams onto the substrate W. Furthermore, it depicts the component patterning means PM1-PM4 as being of a transmissive type; however, it should be noted that the same principles apply to component patterning means of a reflective type. The skilled artisan will appreciate and grasp these points readily.

As here depicted, the wafer table of Figure 1 can be moved back and forth in the direction d. In this manner, a given target portion C on the substrate W can be caused to scan through each of the patterned component projection beams PB1-PB4 emergent from the component patterning means PM1-PM4. If the velocity v of the substrate W in the direction d is correctly matched to the timing/synchronization of pattern generation in the component patterning means PM1-PM4, then the target portion C will, for example, be exposed to each of the patterns shown in the lower part of Figure 3 during its passage through the patterned component projection beams PB1-PB4. This is a serial exposure instead of the parallel exposure depicted in Figure 2.

As an alternative to moving the substrate W through the beams PB1-PB4, one may, of course, also move the beams PB1-PB4 and keep the substrate stationary.

The techniques of using multiple components patterning means simultaneously exposed may, of course be combined with the technique of using multiple exposures of the same patterning means to produce additional gray "tints". In this case, the pattern on a target portion of the substrate is the result of two or more successive exposures of two or more component patterning means that are simultaneously projected onto the target portion of the substrate. The intensities and the pattern can be different for each component patterning means and for each exposure.

It is also possible to use only a single programmable patterning means to repeatedly expose the target portion C, changing the illumination level and the pattern between each exposure.

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a first projection beam of radiation;
- first programmable patterning means for patterning the first projection beam according to a first desired pattern;
- a substrate table for holding a substrate;
- a projection system for projecting the first patterned projection beam onto a target portion of the substrate,
**characterized in that** said apparatus further comprises second programmable patterning means for patterning a second projection beam provided by the radiation system according to a second desired pattern;
said projection system projects the second patterned projection beam onto said target portion of the substrate; and
the intensities of the first and second patterned projection beams are different.

2. A lithographic projection apparatus according to claim 1, wherein the patterns for each programmable patterning means may be different such that a sub-area within the target portion may be exposed by any one of: the first projection beam; the second projection beam; neither projection beam; and both projection beams.

3. A lithographic projection apparatus according to claim 1 or 2, wherein the radiation system comprises a beam splitter configured to provide the first and second projection beams, such that said first and second projection beams have different intensities.

4. A lithographic projection apparatus according to claim 1, 2 or 3, wherein a variable attenuator is provided to adjust the intensity of at least one of said first and second projection beams and said first and second patterned projection beams.

5. A lithographic projection apparatus according to any one of the preceding claims, wherein the radiation system comprises first and second radiation sources, the intensities of which can be independently set, that provide said first and second projection beams, respectively.

6. A lithographic projection apparatus according to any one of the preceding claims, wherein the first and second patterned projection beams are combined into a single patterned projection beam that is projected onto the target portion of the substrate by the projection system.

7. A lithographic projection apparatus according to any one of claims 1 to 5, wherein the first and second patterned projection beams are independently projected onto the target portion of the substrate.

8. A lithographic projection apparatus according to any one of the preceding claims, wherein the apparatus is adapted to project at least a second exposure patterned by at least one of said programmable patterning means onto said target portion of the substrate.

9. A device manufacturing method comprising the steps of:
- providing a substrate that is at least partially covered by a layer of radiation sensitive material;
- providing a first projection beam of radiation using a radiation system;
- using first programmable patterning means to endow the first projection beam with a first pattern in its cross-section;
- projecting the first patterned projection beam of radiation onto a target portion of the layer of radiation-sensitive material,
**characterized by**
- providing a second projection beam of radiation;
- providing second programmable patterning means to endow the second projection beam with a second pattern in its cross-section; and
- projecting the second patterned projection beam of radiation onto said target portion of the layer of radiation sensitive material;
wherein said first and second patterned projection beams have different intensities.
